# EUROPEAN PATENT APPLICATION

(11) **EP 1 801 880 A2**
(43) Date of publication of application: **27.06.2007**
(21) Application number: 06018860.4
(22) Date of filing: 08.09.2006
(51) Int. Cl.: H01L 27/32

(54) **Organic electroluminescent device comprising scan lines having the same resistance**

(30) Priority: 22.12.2005 KR 20050127955
(71) Applicant: LG Electronics Inc., Yongdungpo-Gu Seoul 150-010 (KR)
(72) Inventor: Bae, Hyo Dae, Dalseo-gu Daegu 704-130 (KR)
(74) Representative: von Hellfeld, Axel

(57) **Abstract**

The present invention discloses the organic electroluminescent device in which a plurality of scan lines (310a,310b) can be arranged without the spatial limitation to maintain identically resistances of the scan lines (310a,310b). The organic electroluminescent device according to the present invention comprising a plurality of scan lines (310a,310b) connected electrically a plurality of cathode electrodes (304) is characterized in that each scan line has a length which is the same as that (those) of the neighboring scan line(s). The scan line (310a,310b) has at least one portion which is bent with a certain angle, and the bending frequency of any one scan line is more than that of the scan line formed at an outer side thereof. Also, the bending angle of the bent portion of any one scan line is smaller than that of the scan line formed at an outer side thereof.

## Description

### BACKGROUND OF THE INVENTION

### Field of the Invention

The present invention relates to an organic electroluminescent device, particularly relates to an organic electroluminescent device which can be driven stably by scan lines having the same resistance values.

### Description of the Related Art

Organic electroluminescence is the phenomenon which excitons are formed in an (low molecular or high molecular) organic material thin film by re-combining holes injected through an anode with electrons injected through a cathode, and light with specific wavelength is generated.

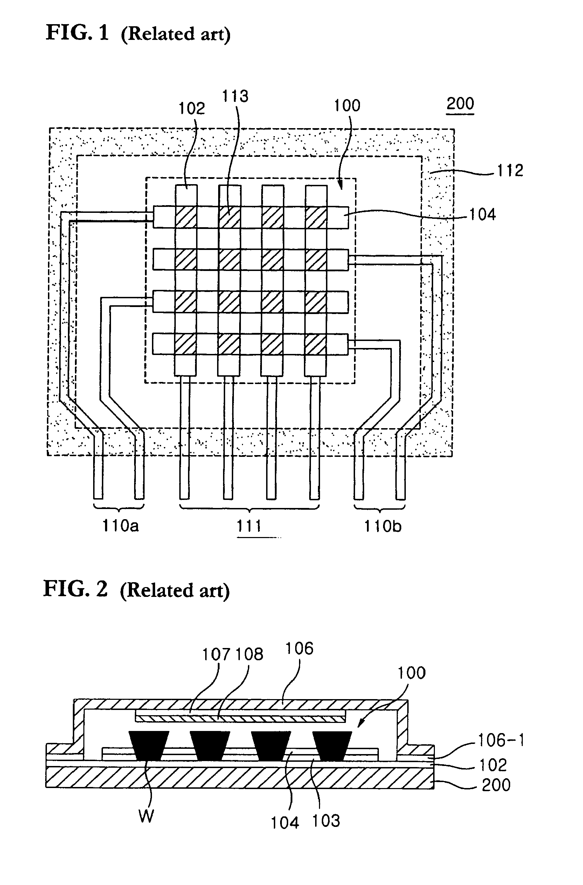

The organic electroluminescent device using the above phenomenon has a basic structure as illustrated in Fig. 1. The basic structure of the organic electroluminescent device includes a glass substrate **200,** an indium-tin-oxide layer **102** (hereinafter, referred as "ITO layer") formed on the upper side of the glass substrate **200** and acting as anode electrode, an insulating layer, an organic material layer, and a metal layer **104** acting as cathode electrode in the order. Walls (not shown) are formed to deposit the metal layers **104** separately on the ITO layer **102.**

Fig. 2 is a sectional view of the organic electroluminescent device shown in Fig. 1 and shows that a cap **106** is bonded to the substrate **200** as shown in Fig. 1. As shown in Fig. 2, a plurality of data lines **111** and scan lines **110a** and **110b** are formed on an outer portion of an active area **100** including a plurality of ITO layers **102** (anode electrodes) and a plurality of metal layers **104** (cathode electrodes). The data lines **111** and the scan lines **110a** and **110b** are connected electrically to the anode electrodes **102** and the cathode electrodes **104.** In Fig. 2, reference numeral **"108"** which is not described indicates a moisture absorbent sheet (so called as "getter") attached to an inner surface of the cap **106** through an adhesive **107.**

For convenience' sake, on the other hand, only four (4) anode electrodes **102** and four (4) data lines **111,** four (4) cathode electrodes **104** and four (4) scan lines **110a** and **110b** are shown in Fig. 1, however, in actual, much more electrodes and lines are formed on the substrate **200.**

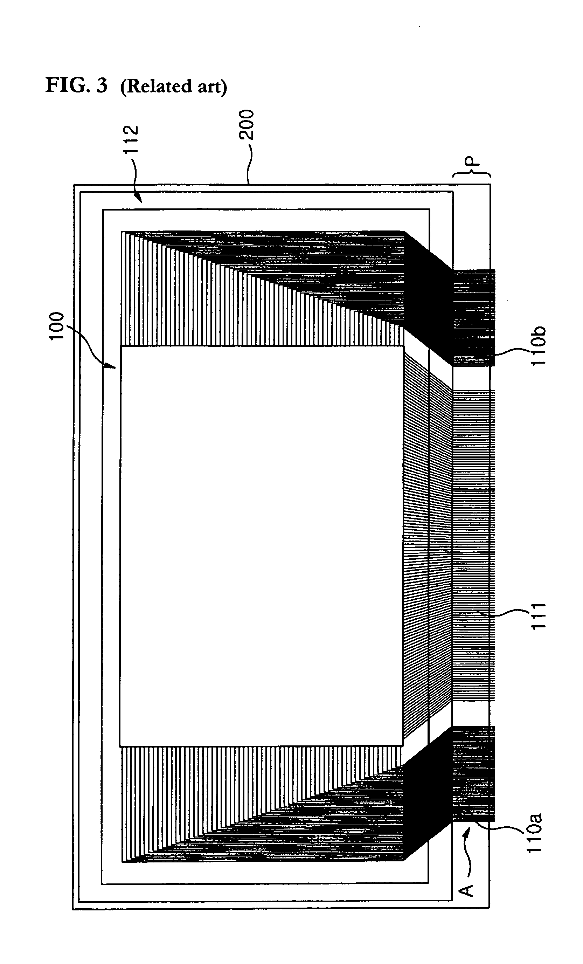

Fig. 3 is a plane view of an entire organic electroluminescent device shown in Fig. 1 except the cap **106** and shows a configuration of the actual organic electroluminescent device. As shown in Fig. 3, a plurality of data lines **111** connected to the anode electrodes 102 in the active area **100,** respectively, have the same length practically and end portions thereof are arranged on a connecting section **P.**

However, a plurality of scan lines **110a** and **110b** connected to ends of the cathode electrodes **104** are extended outsides of the active area **100** and then disposed on the connecting section **P** formed at a location adjacent to the active area **100** through an end portion thereof.

Due to such configuration, that is, an extension direction of each scan line **110a** and **110b** and a location of the connecting section **P,** lengths of the scan lines **110a** and **110b** differ from each other. That is, in the scan lines **110a** and **110b** formed in the same area, the outermost scan line has the longest length and the scan line adjacent to the active area **100** has the shortest length.

As described above, the lengths of the scan lines **110a** and **110b** differ from each other according to the locations thereof, consequently, resistances of the scan lines are different from each other. In general, the data current is flow to a ground through the data line, the pixel and the scan lines, and so the resistance of scan line has influence on the cathode voltage of the corresponding pixel (that is, a brightness of the pixel).

Accordingly, if the resistances of the scan lines **110a** and **110b** differ from each other, although the same current is applied to the pixels, the pixels emit the lights with the brightness which differ from each other. Consequently, different resistances of the scan lines cause a brightness difference among the pixels when the display device is operated, and due to the above phenomenon, the display failure is generated.

### SUMMARY OF THE INVENTION

The present invention is conceived to solve the above problem caused by a resistance difference among the scan lines constituting the organic electroluminescent device, an object of the present invention is to provide the organic electroluminescent device in which a plurality of scan lines are arranged to maintain identically resistances of the scan lines.

The organic electroluminescent device according to the present invention comprises an active area consisting of anode electrodes, organic material layer and cathode electrodes; data lines connected to the anode electrodes for transmitting electrical signal to the anode electrodes; and scan lines connected to the cathode electrodes for transmitting electrical signal to the cathodes, wherein each scan line has a length which is the same as that (those) of neighboring scan line(s).

In the organic electroluminescent device according to the present invention, the scan line has at least one portion which is bent with a certain angle, and the bending frequency of one scan line is more than that of the scan line formed at an outer side thereof. Also, the bending angle of the bent portion of one scan line is smaller than that of the scan line formed at an outer side thereof.

Further, in the organic electroluminescent device according to the present invention, each of the scan lines can have at least one curved portion. At this time, the curved portion of one scan line is smaller than that of the curved portion of the scan line formed at an outer side thereof.

### BRIEF DESCRIPTION OF THE DRAWINGS

These and other features, aspects and advantages of the present invention will become better understood with regard to the following description, appended claims, and accompanying drawings where:

Fig. 1 is a plane view illustrating schematically a basic structure of organic electroluminescent device;

Fig. 2 is a sectional view of an organic electroluminescent device, shown in Fig. 1, on which a cap is bonded;

Fig. 3 is a plane view of an entire organic electroluminescent device shown in Fig. 1;

Fig. 4 is a plane view illustrating schematically a basic structure of the organic electroluminescent device according to the present invention;

Fig. 5 is a detail view corresponding to "A" section of Fig. 3 and shows only some of scan lines constituting the organic electroluminescent device shown in FIG. 4; and

Fig. 6 is a view corresponding to Fig. 5 and shows another configuration of the scan lines constituting the organic electroluminescent device according to the present invention.

### DETAILED DESCRIPTON OF THE INVENTION

Hereinafter, the preferred embodiments of the present invention will be described in detail with reference to the accompanying drawings. In the following embodiments, the organic electroluminescent device is provided as an example of the light emitting device. It is, however, obvious that the teaching of the present invention is not limited to the organic electroluminescent device.

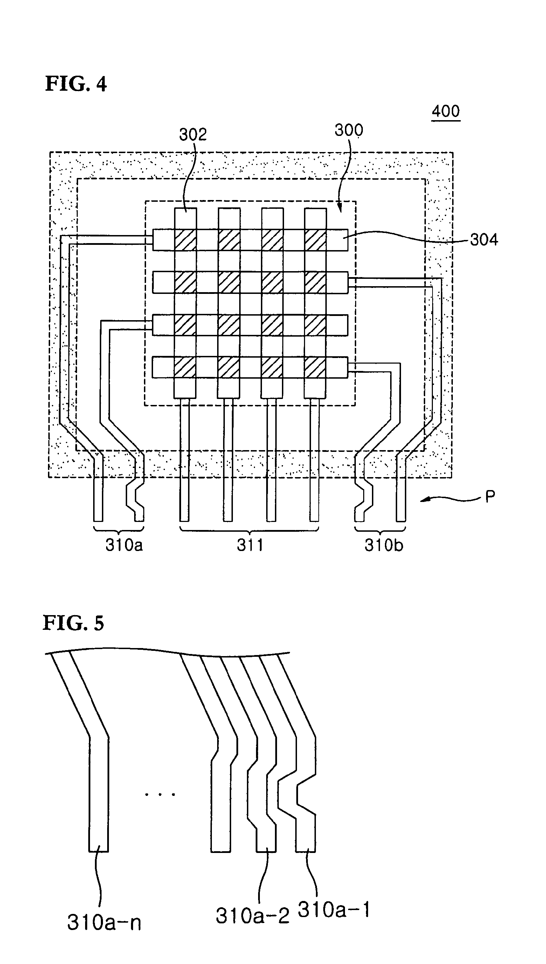

In the organic electroluminescent device according to the present invention as shown in Fig. 4, a plurality of data lines **311** and scan lines **310a** and **310b** are formed on an outside of an active area **300** on which anode electrodes **302** and cathode electrodes **304** are formed. The data lines **311** and the scan lines **310a** and **310b** are connected electrically to the anode electrodes **302** and the cathode electrodes **304.**

As shown in Fig. 4, a plurality of data lines **311** connected to the anode electrodes **302** in the active area **300,** respectively, have the same length practically and end portions thereof are arranged on a connecting section **P.**

The most import feature of the present invention is that the scan lines **310a** and **310b** have non-linear sections such that the lengths of the scan lines are the same, and so all the scan lines have the same resistance.

Fig. 5 is a detail view corresponding to "A" section of Fig. 3 and shows only some of the scan lines constituting the organic electroluminescent device according to the present invention. In Fig. 5, on the other hand, reference numerals **310a-1, 310a-2** ... **310a-n** indicate the scan lines.

In the present invention, as shown in Fig. 4 and Fig. 5, the innermost scan line **310a-1** (hereinafter, referred to as "first scan line") formed on an area which is most adjacent to the active area (**300** in Fig. 4) is bent several times, and the scan line **310a-2** (second scan line) formed on an outside of the first scan line **310a-1** is also bent several time. However, a bending angle of each bent portion of the second scan line **310a-2** is larger than that of the first scan line **310a-1,** and the bending frequency of the second scan line **310a-2** can be less than that of the first scan line **310a-1.** Accordingly, the entire length of the second scan line **310a-2** is the same as that of the first scan line **310a-1**.

By applying the configuration described above to all the scan lines, a length of any one scan line becomes identical to that (those) of the neighboring scan line(s), and so all the scan lines **310a-1, 310a-2** ... **310a-n** have the same length and the same resistance.

Here, end portions of the scan lines **310a-1, 310a-2** ... **310a-n** should be disposed on the connecting section (**P** in Fig. 4).

On the other hand, although Fig. 5 shows that all the scan lines **310a-1, 310a-2** ... **110a-n** have the same length by bending the scan lines at a certain angle, the configuration of the scan lines is not limited to that shown in Fig. 5.

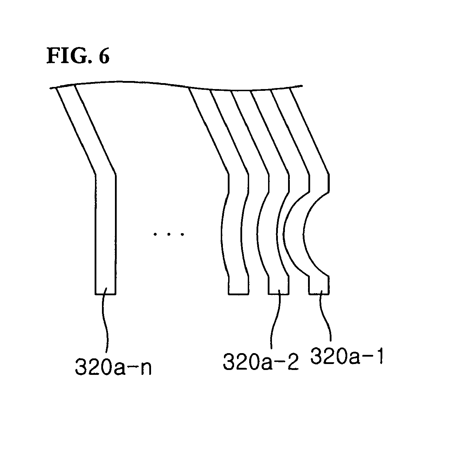

Fig. 6 is a view corresponding to Fig. 5 and shows another configuration of the scan lines constituting the organic electroluminescent device according to the present invention. As shown in Fig. 6, each of the scan lines **320a-1, 320a-2** ... **320a-n** can have at least one curved shaped portion. At this time, and the radius of curvatures of curved portions of the scan lines **320a-1, 320a-2** ... **320a-n** differ from each other.

That is, a radius of curvature of a curved portion of any one scan line, for example, a radius of curvature of the curved portion of the first scan line **320a-1** neighboring the active area (**300** in Fig. 4) is less than that of the second scan line **320a-2** formed at an outer side of the first scan line **320a-1.**

By applying the configuration described above to all the scan lines, a length of any one scan line becomes identical to that (those) of the neighboring scan line(s), and so all the scan lines **320a-1, 320a-2** ... **320a-n** have the same length and the same resistance.

Here, end portions of the scan lines **320a-1, 320a-2** ... **320a-n** should be disposed on the connecting section (**P** in Fig. 4).

Further scope of applicability of the present invention will become apparent from the above detailed description. However, it should be understood that the detailed description and specific examples, while indicating preferred embodiments of the invention, are given by way of illustration only, since various changes and modifications within the spirit and scope of the invention will become apparent to those skilled in the art from this detailed description.

For example, although Fig. 4 shows the configuration of the organic electroluminescent device in which the scan lines **310a, 310b** connected to the cathode electrodes **304** are extended alternatively from both sides of the active area **300,** the present is applicable to the organic electroluminescent device having the configuration in which all the scan lines are extended from only one side of the active area.

Also, the present is applicable to the organic electroluminescent device in which some scan lines connected to the cathode electrodes disposed on a first region of the active area are extended from one side of the active area and remainder of the scan lines connected to the cathode electrodes formed on a second region of the active area are extended from the other side of the active area.

If the present invention is applied to the various kinds of the display devices comprising a plurality of metal lines, all the metal lines have the same length and the same resistance.

In the organic electroluminescent device with the structure as described above, although locations of the scan lines on the outer regions of the active area differ from each other, the scan lines formed such that all of the scan lines have the same length, and so all of the scan lines have the same resistance.

Accordingly, for example, if the current flowed through a first scan line when the first scan line is coupled to a ground is the same in a magnitude as the current flowed through a second scan line when the second scan line is coupled to a ground, since resistance of the first scan line is the same as that of the second scan line, a cathode voltage of the first pixel associated with the first scan line is substantially identical with a cathode voltage of the second pixel associated with the second scan line and corresponding to the second pixel in a magnitude. Consequently, if the data current with the same magnitude are applied to the first and second pixels, the first and second pixels emit the light with the same brightness when the display device is operated.

The preferred embodiments of the present invention have been described for illustrative purposes, and those skilled in the art will appreciate that various modifications, additions, and substitutions are possible, without departing from the scope and spirit of the present invention as disclosed in the accompanying claims.

## Claims

1. An organic electroluminescent device, comprising
an active area including anode electrodes, organic material layer and cathode electrodes;
data lines connected to the anode electrodes for transmitting electrical signal to the anode electrodes; and
scan lines connected to the cathode electrodes for transmitting electrical signal to the cathodes, wherein each scan line has a length which is the same as that (those) of neighboring scan line(s).

2. The organic electroluminescent device of claim 1, wherein the scan line has at least one portion which is bent with a certain angle.

3. The organic electroluminescent device of claim 2, wherein the bending frequency of the scan line is more than that of the scan line formed at an outer side thereof.

4. The organic electroluminescent device of claim 3, wherein the bending angle of the bent portion of the scan line is smaller than that of the scan line formed at an outer side thereof.

5. The organic electroluminescent device of claim 1, wherein the scan line has at least one curved portion with a certain radius of curvature.

6. The organic electroluminescent device of claim 5, wherein the curved portion of the scan line has a radius of curvature which is smaller than that of the curved portion of the scan line formed at an outer side thereof.

7. The organic electroluminescent device of claim 1, wherein the scan lines connected to the cathode electrodes are extended alternatively from both sides of the active area.

8. The organic electroluminescent device of claim 1, wherein some of the scan lines connected to the cathode electrodes disposed on one region of the active area are extended from one side of the active area and remainder of the scan lines connected to the cathode electrodes disposed on the other region of the active area are extended from the other side of the active area.

9. The organic electroluminescent device of claim 1, wherein the scan lines connected to the cathode electrodes are extended from only one side of the active area.

10. An organic electroluminescent device, comprising
an active area including anode electrodes, organic material layer and cathode electrodes;
data lines connected to the anode electrodes for transmitting electrical signal to the anode electrodes; and
scan lines connected to the cathode electrodes for transmitting electrical signal to the cathodes, wherein the scan has at least one portion which is bent with a certain angle.

11. The organic electroluminescent device of claim 10, wherein the bending frequency of the scan line is more than that of the scan line formed at an outer side thereof.

12. The organic electroluminescent device of claim 11, wherein the bending angle of the bent portion of the scan line is smaller than that of the scan line formed at an outer side thereof.

13. An organic electroluminescent device, comprising
an active area including anode electrodes, organic material layer and cathode electrodes;
data lines connected to the anode electrodes for transmitting electrical signal to the anode electrodes; and
scan lines connected to the cathode electrodes for transmitting electrical signal to the cathodes, wherein the scan has at least one curved portion,

14. The organic electroluminescent device of claim 13, wherein the curved portion of the scan line has a radius of curvature which is smaller than that of the curved portion of the scan line formed at an outer side thereof.
